# EUROPÄISCHE PATENTSCHRIFT

(11) **EP 2 001 119 B1**
(45) Veröffentlichungstag und Bekanntmachung des Hinweises auf die Patenterteilung: **30.07.2014**
(21) Anmeldenummer: 07075450.2
(22) Anmeldetag: 06.06.2007
(51) Int. Cl.: H02P 7/29, H02M 3/155, H03K 17/0412

(54) **Steuerschaltung für einen Gleichstrommotor**
Control circuit for a DC motor
Circuit de commande pour un moteur à courant continu

(43) Veröffentlichungstag der Anmeldung: 10.12.2008
(73) Patentinhaber: Schwoch, Marko, 12557 Berlin (DE)
(72) Erfinder: Schwoch, Marko, 12557 Berlin (DE)
(74) Vertreter: Theobald, Andreas

(56) Entgegenhaltungen:
- GB-A- 2 158 305
- JP-A- 56 087 930

## Beschreibung

Die vorliegende Erfindung betrifft einer Steuerschaltung für einen Gleichstrommotor und insbesondere eine Steuerschaltung für einen PC-Lüfter. Daneben betrifft die vorliegende Erfindung einen PC-Lüfter.

Mit den in der Vergangenheit immer weiter zunehmenden Taktraten und der damit verbundenen Wärmeentwicklung von PC-Komponenten wie etwa der zentralen Prozessoreinheit (CPU) oder Grafikchips hat eine zuverlässige Kühlung des PCs immer mehr an Bedeutung gewonnen. Entsprechendes gilt auch für andere Wärme erzeugende elektronische Komponenten sowie andere Geräte, die derartig Komponenten verwenden, bspw. Kopierer, Drucker, etc. Die Kühlung erfolgt über einen oder mehrere Lüfter, die einen Gleichstrommotor zum Antrieben eines Rotors und eine Steuerschaltung zur Regelung der Drehzahl des Rotors aufweisen.

Eine Möglichkeit, die Motordrehzahl zu regeln basiert auf der so genannten Pulsweitenmodulation (PWM), in der ein Temperatursignal, welches die Temperatur der zu kühlenden Einrichtung wiedergibt, im Form von rechteckförmigen Pulsen mit einer bestimmten Pulsdauer dargestellt wird. Je länger der Pulsdauer ist, desto höher ist die Temperatur und desto mehr Kühlungsbedarf besteht. Ein derartiges pulsweitenmoduliertes Signal, im Folgenden PWM-Signal genannt, kann bspw. in eine Tiefsetzstellerschaltung (auch Step-Down-Converter, Abwärtsregler oder Abwärtswandler genannt) eingespeist werden, in der eine Ausgangsspannung produziert wird, deren Höhe von der Pulsdauer abhängt. Eine derartige Schaltung ist bspw. in US 6,285,146 B1 beschrieben. Die von dieser Schaltung erzeugte Ausgangsspannung spannung wird an die Spulen eines bürstenlosen Gleichstrommotors angelegt. Mittels einer Logikschaltung wird die Verteilung der von der Tiefsetzstelleschaltung ausgegebenen Spannung auf die beiden Spulen des Motors geregelt. In der US 6,285,146 B1 werden die Abmessungen einer Spule und eines Kondensators, die Komponenten der Tiefsetzstelleschaltung sind, als nachteilig beschrieben. Es wird daher eine kompliziertere Schaltung, die jedoch besser zu miniaturisieren ist, vorgeschlagen. Mit der aufwändigeren Schaltung sind jedoch auch höhere Kosten verbunden, was bei einem Massenprodukt wie bspw. einem PC-Lüfter nachteilig ist.

Eine andere Vorgehensweise zur Regelung der Rotorgeschwindigkeit ist in US 2004/0164692 A1 beschrieben. Dort erfolgt die Regelung der Rotorgeschwindigkeit auf der Basis eines PWM-Signals mit Hilfe einer Steuerlogikschaltung, die dazu dient, eine Versorgungsspannung geeignet getaktet auf die beiden Spulen eines Gleichstrommotors zu verteilen. Nur dann, wenn das PWM-Signal einen hohen Pegel aufweist, werden den Spulen zugeordnete Schalttransistoren wechselweise geöffnet, so dass das in den Spulen entstehende Magnetfeld den Rotor antreibt. Weist das PWM-Signal hingegen einen niedrigen Pegel auf, werden die Transistoren geschlossen, so dass eine antreibende Kraft für den Rotor nicht vorhanden ist. Dem Steuereingang der Logikschaltung ist eine Inverterschaltung vorgeschaltet, welche das PWM-Signal invertiert. Das invertierte PWM-Signal dient dann als das eigentliche Steuersignal für die Logikschaltung. Die Steuerung erfolgt in US 2004/0164692 A1 also alleine durch Ein- bzw. Ausschalten des Lüfters. Eine Geschwindigkeitsregelung für den Rotor durch Regeln der Höhe der Versorgungsspannung des Motors erfolg hingegen nicht.

GB 2 158 305 A beschreibt eine Spannungswandlerschaltung mit einer Hauptstufe und einer Vorstufe, wobei die Hauptstufe als Tiefsetzstellerschaltung mit einem PNP-Transistor als Schalter ausgebildet ist. Die Vorverstärkerstufe umfasst ebenfalls einen PNP-Transistor, dessen Hauptstrompfad zwischen die Basis des Transistors der Tiefsetzstellerschaltung und eine Spulenanzapfung in der Spule der Tiefsetzstellerschaltung geschaltet ist.

JP 56087930 A beschreibt eine Schaltschaltung, in der die Basis eines Transistors mittels einer Parallelschaltung aus einem Widerstand und einem Kondensator kontaktiert ist.

Aufgabe der vorliegenden Erfindung ist es gegenüber diesem Stand der Technik eine vorteilhafte Steuerschaltung für einen Gleichstrommotor zur Verfügung zu stellen, die insbesondere besonders kostengünstig herzustellen ist.

Es ist eine weitere Aufgabe der vorliegenden Erfindung, einen vorteilhaften PC-Lüfter zur Verfügung zu stellen, der insbesondere kostengünstig hergestellt werden kann.

Die erste Aufgabe wird durch eine Steuerschaltung für einen Gleichstrommotor nach Anspruch 1 gelöst, die zweite Aufgabe durch einen PC-Lüfter nach Anspruch 9. Die abhängigen Ansprüche enthalten vorteilhafte Ausgestaltungen der Erfindung.

Eine erfindungsgemäße Steuerschaltung für einen Gleichstrommotor umfasst eine Vorstufe und eine Hauptstufe. Die Vorstufe ist als Vorverstärker mit einem Steuersignaleingang und einem Vorstufenausgang zur Ausgabe eines vorverstärkten Steuersignals ausgebildet. Die Hauptstufe ist als Tiefsetzstellerschaltung ausgebildet, welche einen Transistor, im Folgenden Hauptstufentransistor genannt, als Schalter aufweist, dessen Steuereingang mit dem Vorverstärkerausgang verbunden ist. Als einziges aktives Element weist die Vorstufe einen Transistor mit einem Steueranschluss, der mit dem Steuersignaleingang verbunden ist, auf. Der Hauptstrompfad dieses Transistors ist zwischen den Versorgungsspannungseingang und Masse geschaltet und über wenigstens einen Widerstand mit dem Vorverstärkerausgang verbunden.

In der erfindungsgemäßen Steuerschaltung kann die Geschwindigkeit des Gleichstrommotors durch Einstellen der Ausgangsspannung der Tiefsetzstellerschaltung geregelt werden. Die Steuerung erfolgt über ein PWM-Steuersignal, das am Steuersignaleingang der Vorstufe anliegt. Die erfindungsgemäße Schaltung toleriert dabei auch PWM-Signale, deren Signalform erheblich von der eigentlichen Rechteckform eines PWM-Signals abweichen und bspw. annähernd Sägezahnform oder Sinusform aufweist.

Die Tiefsetzstellerschaltung dient in der erfindungsgemäßen Steuerschaltung dazu, eine Ausgangsspannung zur Verfügung zu stellen, deren Höhe von der Pulsweite des PWM-Signals abhängt. Daneben erfolgt in der Tiefsetzstellerschaltung eine Stromverstärkung und eine Nachtriggerung des PWM-Signals. Da das PWM-Signal lediglich zum Öffnen und Schließen des Hauptstufentransistors Verwendung findet, kann die Ausgangsspannung der Tiefsetzstellerschaltung - und damit die Versorgungsspannung für den Gleichstrommotor - unabhängig von dem Spannungspegel des PWM-Signals eingestellt werden.

Die Vorstufe dient in der erfindungsgemäßen Steuerschaltung zur Spannungsverstärkung, zur Stromverstärkung und zur Triggerung auf der Basis des am Signaleingang anliegenden PWM-Signals. Die Stromverstärkung in der Vorstufe vermeidet bzw. reduziert stark Rückwirkungen von der Endstufe auf das Eingangssignal.

Die Vorstufe kann besonders kostengünstig hergestellt werden, wenn sie als einziges aktives Element einen Transistor, im Folgenden Vorstufentransistor genannt, umfasst, dessen Steueranschluss mit dem Signaleingang verbunden ist. Als Vorstufentransistor kann sowohl ein bipolarer Transistor als auch ein Feldeffekttransistor (FET) zum Einsatz kommen, wobei bipolare Transistoren kostengünstiger sind. Gleiches gilt für den Hauptstufentransistor. Insbesondere kann der Vorstufentransistor ein npn-Transistor (im Falle eines Bipolartransitors) bzw. ein n-Kanal-Transistor (im Falle eines Feldeffekttransistors) und der Hauptstufentransistor ein pnp-Transistor (im Falle eines bipolaren Transistors) bzw. ein p-Kanal-Transistor (im Falle eines Feldeffekttransistors) sein. Da bipolare Transistoren in der Regel kostengünstiger als Feldeffekttransistoren sind, ist es im Hinblick auf eine Minimierung der Herstellungskosten für die Steuerschaltung vorteilhaft, als Vorstufentransistor und/oder als Hauptstufentransistor jeweils einen bipolaren Transistor zu verwenden.

Um eine besonders hohe Toleranz gegenüber PWM-Signalen, deren Signalform stark von der Rechteckform abweicht, zu erhalten, kann der Vorstufentransistor und ggf. auch der Hauptstufentransistor in Übersteuerung betrieben werden. Mit anderen Worten, die Transistoren werden im so genannten Sättigungsmodus betrieben, in dem der durch den Transistor fließende Strom konstant und unabhängig vom Steuersignal ist. Voraussetzung ist, dass im Falle des bipolaren Transistors der Basisstrom eine bestimmte Höhe überschreitet. Im Falle eines Feldeffekttransistors muss die Gatespannung einen bestimmten Schwellenwert überschritten haben, damit dieser im Sättigungsmodus betrieben wird.

Der Betrieb im Sättigungsmodus führt dazu, dass bei Anliegen eines hohen Steuersignalspegels am Steuersignaleingang eines npn-Transistors ein vom Steuersignalpegel unabhängiger und hoher Stromfluss durch den Transistor generiert wird. Zudem steigt der Strom rasch auf den Sättigungswert an, so dass eine steile Flanke im generierten Stromsignal erzeugt wird. Der Transistor kann damit auch vorteilhaft zur Triggerung der Motorsteuerung Verwendung finden. Selbst wenn statt eines PWM-Signals bspw. ein mehr oder weniger sinusförmiges Steuersignal am Steuersignaleingang des Transistors im Sättigungsmodus anliegt, so steigt der durch den Transistor fließende Strom rasch auf den Sättigungsstrom an. Auf diesem Wert bleibt er solange konstant, bis das Steuersignal am Steuersignaleingang wieder den niedrigen Pegel annimmt. Das Ergebnis ist daher auch bei dem Sinussignal oder einem anderen Steuersignal, welches stark von der Rechteckform abweicht, ein durch den Transistor fließender Strom, der einen weitgehend rechteckförmigen Verlauf aufweist. Dieses weitgehend rechteckförmige Signal kann dann zum Betätigen des Hauptstufentransistors Verwendung finden. Eine hocheffektive Nachtriggerung kann erfolgen, wenn auch der Hauptstufentransistor im Sättigungsmodus betrieben wird. So wie der Vorstufenstransistor Abweichungen des PWM-Signals von der Rechteckform korrigiert, kann auch der Hauptstufentransistor beim Betrieb im Sättigungsmodus ein noch von der idealen Rechteckform abweichendes Ausgangssignal der Vorstufe zur exakten Triggerung verwenden. In der Regel genügt es jedoch, wenn der Vorstufentransistor alleine im Sättigungsmodus betrieben wird.

Dem Vorstufentransistor kann eine Parallelschaltung aus einem Widerstand und einem Kondensator vorgeschaltet sein, welche die Triggerung verbessert. Der Kondensator führt dazu, dass bei einem nicht konstanten Strom dieser der Spannung voranseilt. Wenn nun das PWM-Signal am Signaleingang der Vorstufe einen hohen Spannungspegel besitzt, bedeutet dies, dass bereits ein hinreichend großer Strom am Steuereingang des Transistors anliegt, um diesen in den Sättigungsmodus zu treiben, wenn die nachlaufende Spannung den Steuersignaleingang erreicht. Auf diese Weise kann eine zuverlässige Triggerung sichergestellt werden. Entsprechend kann auch dem Hauptstufentransistor eine Parallelschaltung aus einem Widerstand und einem Kondensator vorgeschaltet sein. Wenn das PWM-Signal einen Konstanten Pegel aufweist kann es über den Widerstand weitergeleitet werden.

Die Tiefsetzstellerschaltung kann insbesondere einen Versorgungsspannungseingang und eine Induktivität umfassen, wobei der Hauptstufentransistor zwischen den Versorgungsspannungseingang und die Induktivität geschaltet ist. In diesem Fall kommt als Hauptstufentransistor ein pnp-Transistor bzw. ein p-Kanal-Feldeffekttransistor zur Anwendung.

In einer vorteilhaften Weiterbildung der erfindungsgemäßen Steuerschaltung weist die Vorstufe einen Widerstand auf, der zwischen den Signaleingang und einen Verscrgungsspsrinungseingang geschaltet ist. Mit diesem Widerstand lässt sich erreichen, das dann, wenn der Steuersignaleingang der Vorstufe offen ist, die Steuerschaltung ein Signal ausgibt, welches zur maximalen Motorgeschwindigkeit führt. Bspw. im Falle eines PC-Lüfters kann damit vermieden werden, dass eine Unterbrechung des PWM-Signals zur Überhitzung einer Komponente des PCs führt.

Ein erfindungsgemäßer PC-Lüfter ist mit einer erfindungsgemäßen Steuerschaltung ausgestattet. Die damit verbundenen Vorteile entsprechen den Vorteilen, die bereits mit Bezug auf die Steuerschaltung beschrieben worden sind.

Weitere Merkmale, Eigenschaften und Vorteile der vorliegenden Erfindung ergeben sich aus der nachfolgenden Beschreibung von Ausführungsbeispielen unter Bezugnahme auf die beiliegenden Figuren.

Figur 1 zeigt einen erfindungsgemäßen PC-Lüfter in einem Blockschaltbild.

Figur 2 zeigt ein erstes Ausführungsbeispiel für die erfindungsgemäße Steuerschaltung.

Figur 3 zeigt ein zweites Ausführungsbeispiel für die erfindungsgemäße Steuerschaltung.

Figur 4 zeigt ein drittes Ausführungsbeispiel für die erfindungsgemäße Steuerschaltung.

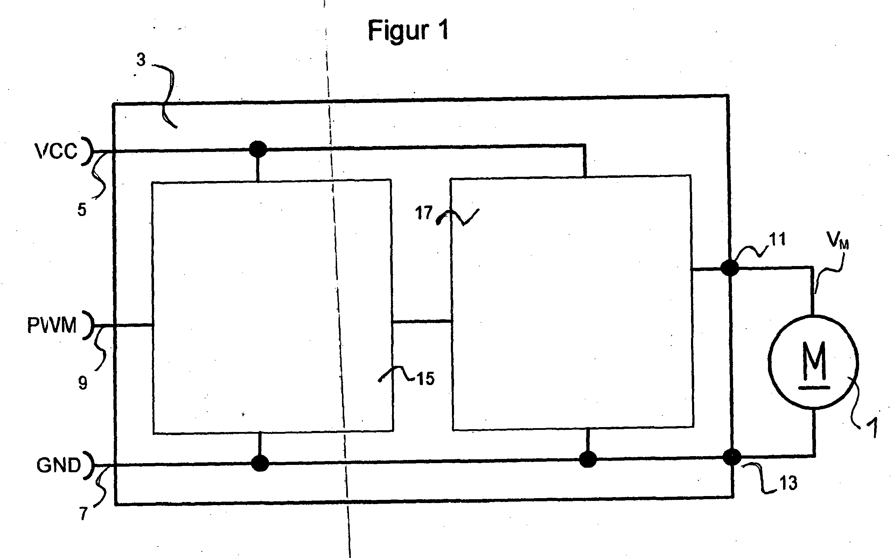

Mit Bezug auf das Blockschaltbild in Figur 1 wird nun ein erfindungsgemäßer PC-Lüfter beschrieben. Der Lüfter umfasst einen Ventilator, der von einem Gleichstromelektromotor angetrieben wird. Der Ventilator ist im Blockschaltbild lediglich durch den Elektromotor 1 repräsentiert. Eine Steuerschaltung 3 stellt dem Gleichstromelektromotor 1 eine Gleichspannung mit einem bestimmten Spannungspegel zur Verfügung. Die Gleichspannung wird in der Steuerschaltung 3 auf der Basis eines PWM-Signals erzeugt, wobei die Dauer eines hohen Spannungspulses ein Maß für die Wärmeentwicklung des vom Lüfter zu kühlenden Gerätes und damit ein Maß für die angeforderte Kühlleistung ist. Auf der Basis der Pulsdauern des PWM-Signals stellt die Steuerschaltung 3 eine Gleichspannung zur Verfügung, deren Pegel zwischen der zum Betrieb des Motors 1 minimal notwendigen Spannung und einer Spannung, die knapp unterhalb der Versorgungsspannung VCC liegt. Die Drehzahl des Motors hängt dabei von der ausgegebenen Gleichspannung, im Folgenden Motorspannung V_{M} genannt, ab.

Die Steuerschaltung 3 umfasst einen Versorgungsspannungseingang 5, einen Masseeingang 7 sowie einen Steuersignaleingang 9, an dem das PWM-Signal anlegt. Sie umfasst weiterhin einen Motorspannungsausgang 11, an dem die Motorspannung V_{M} zur Verfügung gestellt wird, und einen Masseausgang 13. Der Gleichstromelektromotor 1 ist zwischen den Motorspannungsausgang 11 und den Masseausgang 13 geschaltet ist. Die Steuerschaltung 3 umfasst außerdem eine Vorstufe 15 sowie eine Hauptstufe 17. Die Vorstufe dient der Spannungsverstärkung, der Stromverstärkung sowie der Triggerung. Die Hauptstufe dient der Stromverstärkung, einer Nachtriggerung des getriggerten Signals sowie der direkten Steuerung des Motors.

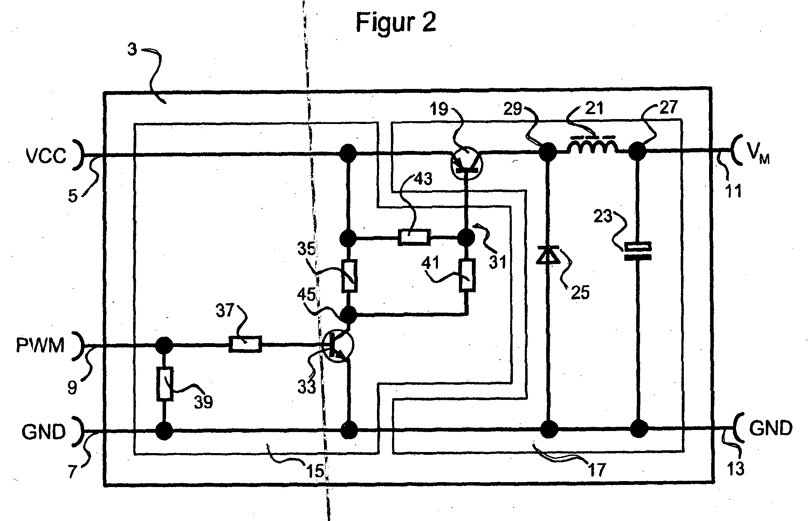

Ein erstes Ausführungsbeispiel für die Steuerschaltung 3 ist in Figur 2 dargestellt. Die Figur zeigt die Vorstufe 15, die Hauptstufe 17, den Versorgungsspannungseingang 5, den Masseeingang 7, den Signaleingang 9, den Motorspannungsausgang 11 sowie den Massenausgang 13.

Die Hauptstufe 17 ist nach dem Tiefsetzstellerprinzip aufgebaut. Ein Tiefsetzsteller, auch Step-Down-Converter, Abwärtsregler oder Abwärtswandler genannt, ist eine elektronische Schaltung zur Abwärtswandlung einer Gleichspannung, in der der Betrag der Ausgangsspannung stets kleiner als der Betrag der Eingangsspannung ist.

Die Hauptstufe 17 umfasst einen Transistor 19, eine Spule 21, einen Kondensator 23 sowie eine Diode 25. Der Transistor 19, der das einzige aktive Element der Hauptstufe darstellt, ist im vorliegenden Ausführungsbeispiel ein pnp-Bipolartransistor, dessen Emitter an den Versorgungsspannungseingang 5 und dessen Kollektor an die Spule 21 angeschlossen ist. Die Spule 21 ist zwischen den Kollektor des Transistors 19 und den Motorspannungsausgang 11 geschaltet. Der Kondensator 23 ist zwischen Masse und einen Knoten 27 geschaltet, der sich zwischen der Spule 21 und dem Motorspannungsausgang 11 befindet. Die Diode 25 ist zwischen Masse und einen Knoten 29 geschaltet, der sich zwischen dem Kollektor des Hauptstufentransistors 19 und der Spule 21 befindet.

Der Hauptstufentransistor 19 dient als Schalter, der einen Strompfad vom Versorgungsspannungseingang 5 zum Motorausgang 11 für den Stromfluss öffnen bzw. schließen kann. Das Verhältnis von Öffnungsdauer zur Summe aus Öffnungsdauer und Schließdauer bestimmt dabei die Höhe der Motorspannung V_{M} am Motorspannungsausgang 11. Das Ein- bzw. Ausschalten des Hauptstufentransistors, und damit das Öffnen und Schließen des Strompfades, wird dabei vom Ausgangssignal der Vorstufe 15 geregelt, welches am Knoten 31, der den Vorstufenausgang bildet, anliegt. Das Ausgangssignal am Knoten 31 ist ein strom- und spannugsverstärktes sowie getriggertes PWM-Signal, das auf der Basis des PWM-Signals am Signaleingang 9 der Vorstufe 15, d.h. des eigentlichen die Temperatur der zu kühlenden Komponente repräsentierenden PWM-Signals, gebildet wird.

Die Vorstufe 15 umfasst als einziges aktives Element einen Vorstufentransistor 33, der im vorliegenden Ausführungsbeispiel als npn-Bipolartransistor ausgestaltet ist und dessen Emitter mit dem Masseeingang 7 verbunden ist. Sein Kollektor ist über einen Widerstand 35 an den Versorgungsspannungseingang 5 angeschlossen. Die Basis des Vorstufentransistors 33 ist über einen Widerstand 37 zum Empfang des PWM-Signals an den Signaleingang 9 angeschlossen. Die Schaltung umfasst weitere Widerstände 39, 41, 43, welche im Wesentlichen zusammen mit den zuvor beschriebenen Widerständen 35, 37 zum Einstellen geeigneter Spannungspegel an verschiedenen Knoten der Vorstufe 15 dienen. Die Widerstände 37, 35 zwischen dem Signaleingang 9 und der Basis des Vorstufentransistors 33 bzw. zwischen dem Versorgungsspannungseingang 5 und dem Kollektor des Vorstufentransistors 33 sind hierbei so aufeinander abgestimmt, dass bei einem hohen Signalpegel des PWM-Signals der Vorstufentransistor 33 im Sättigungsmodus betrieben wird. In diesem Modus ist der an der Basis des Transistors anliegende Spannungspegel höher als der am Kollektor anliegende Spannungspegel und als der am Emitter anliegende Spannungspegel. Dies wird durch die Widerständer 35 und 37 erreicht. Außerdem sind die Widerstandswerte der Widerstände 37, 39 so gewählt, dass ein Strom vom Signaleingang 9 durch die Basis fließt, der hoch genug ist, dass der Sättigungsmodus erreicht wird.

Wenn in der beschriebenen Vorstufe 15 ein hoher Signalpegel am Signaleingang 9 anliegt, übersteigt der an der Basis anliegende Spannungspegel rasch die an Emitter und Kollektor anliegenden Spannungspegel, so dass der Transistor öffnet. Außerdem erfolgt rasch ein Stromfluss durch die Basis, welcher zu einem Betrieb des Transistors 33 im Sättigungsmodus führt. In diesem Modus ist der Kollektorstrom sehr viel höher als der Basisstrom, so dass eine sehr starke Stromverstärkung stattfindet. Mit anderen Worten, der Stromfluss durch den Knoten 45 ist sehr viel höher als der Stromfluss durch den Signaleingang 9.

Aufgrund dessen, dass der Vorstufentransistor 33 sich im Einschaltzustand befindet, ist das Spannungsniveau am Knoten 45 niedrig. Gleichzeitig sind die Widerstandswerte der Widerstände 35, 41 und 43 so gewählt, dass der hohe Stromfluss durch den Knoten 45 zu einem hohen Stromfluss durch den Knoten 31 und zu einem starken Spannungsabfall über den Widerstand 43 führt. Dies hat zur Folge, dass am Knoten 31 das Spannungsniveau sehr stark abfällt. Insgesamt erhält man am Knoten 31, der den Ausgangsknoten der Vorstufe 15 darstellt, ein Rechtecksignal, dass einen hohen Stromfluss und einen niedrigen Spannungspegel am Knoten 31 beinhaltet, wenn das PWM-Signal am Signaleingang 9 einen hohen Pegel aufweist. Da die Versorgungsspannung VCC (bspw. 12V) deutlich über dem hohen Spannungspegel des PWM-Signals (bspw. 5V) liegen kann, ist es möglich, mit der Vorstufe eine Spannungsverstärkung herbeizuführen. Mit anderen Worten, die Spannungsschwankungen am Knoten 31, die als Reaktion auf die Spannungsschwankungen im PWM-Signal am Signaleingang 9 auftreten, sind gegenüber den im PWM-Signal auftretenden Spannungsschwankungen verstärkt. Außerdem dient der Vorstufentransistor 33 zum Triggern der Spannungspulse des am Knoten 31 anliegenden Ausgangssignals der Vorstufe 15. Die Triggerung erfolgt, sobald der Vorstufentransistor 33 in den Sättigungsmodus gebracht wurde und der Sättigungsstrom durch den Kollektor fließt. Durch diese Triggerung lässt sich am Knoten 31 ein Ausgangssignal mit großer Flankensteilheit realisieren.

Der niedrige Spannungspegel am Knoten 31 und der hoher Stromfluss durch den Knoten 45, welche auch zu einem hohen Stromfluss durch den Knoten 31 führt, führt beim Hauptstufentransistor 19 dazu, dass dieser den Strompfad zwischen dem Vorsorgungsspannungseingang 5 und den Motorspannungsausgang 11 öffnet und gleichzeitig in den Sättigungsmodus getrieben wird. Hierbei ist zu beachten, dass der Hauptstufentransistor 19 ein pnp-Transistor ist und daher die Spannungsverhältnisse, die zum Öffnen und zum Sättigungsmodus führen, gegenüber dem als npn-Transistor ausgebildeten Vorstufentransistor 33 umgekehrt sind.

Sobald der Hauptstufentransistor 19 den Sättigungsmodus erreicht hat, fließt ein Strom vom Versorgungsspannungseingang 5 zur Spule 21, dessen Höhe konstant ist, solange sich der Transistor im Sättigungsmodus befindet. Gemessen am Stromfluss durch den Knoten 31 findet hierbei wiederum eine starke Stromverstärkung statt. Mit anderen Worten, der Stromfluss durch den Knoten 27 ist deutlich höher als der Stromfluss durch den Knoten 31. Während der Dauer über die der Hauptstufentransistor 19 im Sättigungsmodus geöffnet ist, fließt durch die Spule 21 und den Gleichstromelektromotor 1 ein Laststrom, die Diode 25 sperrt. Während der Dauer über die der Hauptstufentransistor 19 geöffnet ist, wird außerdem in der Spule 21 Energie gespeichert.

Wenn nun am Signaleingang 9 der Vorstufe ein niedriger Signalpegel des PWM-Signals ankommt, schließt der Vorstufentransistor 33, was zufolge hat, dass der Stromfluss durch den Knoten 31 drastisch reduziert wird und die Spannung am Knoten 31 stark steigt. Als Folge davon verlässt der Hauptstufentransistor 19 den Sättigungsmodus und unterbricht (schließt) den Strompfad. Während der Ausschaltphase wird der durch den Gleichstromelektromotor 1 fließende Laststrom aus der in der Spule 21 gespeicherten Energie gespeist. Er fließt nunmehr über die Diode 25.

Der während der Einschaltphase und der Ausschaltphase am Knoten 27 herrschende Spannungspegel ist im Wesentlichen konstant und hängt vom Verhältnis von Öffnungsdauer des Hauptstufentransistors 19 zur Summe aus Öffnungsdauer und Schließdauer des Hauptstufentransistors 19 ab. Aufgrund der zum Aufladen der Spule und des Kondensators nötigen Energie kommt es zu einer geringfügigen Schwankung der Spannung am Knoten 27 um einen mittleren Spannungspegel. Diese Schwankung wird auch Ripplespannung genannt. Der Ausschlag ihrer Schwankung um den mittleren Spannungspegel wird durch die Induktivität der Spule 21 und die Kapazität des Kondensators 23 bestimmt. Je größer die Induktivität bzw. die Kapazität ist, desto geringer ist der Ausschlag der Ripplespannung, d.h. desto gleichmäßiger ist die Spannung am Knoten 27. Der tatsächliche Wert des Ausschlages basiert in der Regel auf einer Abwägung zwischen der maximal akzeptablen Größen der Spule und des Kondensators einerseits und dem maximal akzeptablen Ausschlag der Ripplespannung, also der gewünschten Gleichmäßigkeit der Ausgangsspannung am Knoten 27, andererseits.

Die Induktivität der Spule 21 und die Kapazität des Kondensators 23 sind im vorliegenden Ausführungsbeispiel so gewählt, dass der der Betrag des Ausschlags der Ripplespannung nicht mehr als 5% des mittleren Spannungspegels, vorzugsweise nicht mehr als 1 % des mittleren Spannungspegels beträgt, so dass am Knoten eine hinreichend gleichmäßige Gleichspannung zur Verfügung steht. Insbesondere, wenn der Gleichstromelektromotor 1 Zusatzfunktionen, bspw. eine Drehzahlausgabefunktion, umfasst, ist es vorteilhaft, wenn der Ausschlag der Ripplespannung maximal 1% beträgt. Eine größere Ripplespannung würde zwar das Steuern der Motordrehzahl nicht wesentlich beeinträchtigen, die Drehzahlerfassung im Rahmen der Sonderfunktion jedoch unter Umständen verfälschen.

Der am Knoten 27 vorhandene Spannungspegel wird als Motorspannung V_{M} am Motorspannungsausgang 11 ausgegeben. Er repräsentiert den dem Gleichstromelektromotor 1 am Knoten 27 zur Verfügung stehenden Gleichspannungspegel. Die Höhe des mittleren Spannungspegels am Knoten 27 hängt, wie bereits zuvor erwähnt, vom Verhältnis der Einschaltdauer des Hauptstufentransistors 19 zur Summe aus Einschalt- und Ausschaltdauer ab. Je größer der Anteil der Einschaltdauer an der Summe aus Einschalt- und Ausschaltdauer ist, desto höher ist der mittlere Spannungspegel am Knoten 27. Durch ein am Signaleingang 9 anliegendes PWM-Signal kann somit der Spannungspegel der Motorspannung V_{M} am Motorspannungsausgang 11 geregelt werden.

Mit der beschriebenen Steuerschaltung 3 können im Wesentlichen alle auf dem Markt angebotenen Standard-Gleichstrommotoren angesteuert und betrieben werden. Die in der Hauptstufe 17 erfolgende Leistungsverstärkung führt zudem zu einer weiteren Triggerung. Dies führt zu einer weiter verbesserten Steilheit des Signals am Knoten 29, wodurch der Wirkungsgrad der Schaltung verbessert und die Verlustleistung des Hauptstufentransistors 19 verringert wird.

Wenn die erfindungsgemäße Steuerschaltung 3 mit einem Gleichstrommotor mit Schleifkontakten betrieben wird, kann außerdem der sonst zur Vermeidung von Funkenbildung übliche Einsatz von Filtern entfallen. Zudem kann die Steuerschaltung sehr kostengünstig hergestellt werden, da sie lediglich den Hauptstufentransistor 19 und den Vorstufentransistor 33 als aktive Elemente umfasst. Diese Transistoren können statt als bipolare Transistoren wie im vorliegenden Ausführungsbeispiel auch als Feldeffekttransistoren, etwa als MOSFETs, ausgebildet sein. Grundsätzlich ist es auch möglich, bipolare Transistoren und Feldeffekttransistoren zu kombinieren, bspw. einen Bipolartransistor in der Vorstufe 15 und einen Feldeffekttransistor in der Hauptstufe 17 oder umgekehrt.

Mit der erfindungsgemäßen Steuerschaltung 3 ist der maximale Spannungspegel am Motorspannungsausgang 11 von der maximalen Spannung des PWM-Signals am Steuersignaleingang 9 der Vorstufe 15 unabhängig. Er ist lediglich durch die Versorgungsspannung VCC und den Spannungsabfall über den Hauptstufentransistor 19 und die Spule 21 bestimmt. So kann bspw. das PWM-Signal einen Maximalpegel von 5 Volt besitzen und der Motor selbst mit bspw. maximal 12 Volt betrieben werden. Diese Unabhängigkeit der maximalen Motorspannung V_{M} von der Maximalspannung des PWM-Signals wird im Wesentlichen durch die hohe Spannungsverstärkung der Vorstufe 15 erreicht.

Aufgrund der Triggerung des am Knoten 31 anliegenden Ausgangssignals der Vorstufe braucht das Eingangssignal am Steuereingang 9 nicht notwendigerweise ein PWM-Signal mit rechteckförmiger Pulsform zu sein. Die Schaltung ist auch einsetzbar, wenn das "PWM-Signal" bspw. Sinusform oder Sägezahnform aufweist. Das Ausgangssignal am Knoten 31 wird mit der relativ hohen Strom- und Spannungsverstärkung nämlich erst dann erzeugt, wenn die Triggerung erfolgt, mit anderen Worten, erst dann, wenn der Basisstrom am Vorstufentransistor 33 hoch genug ist, um diesen in den Sättigungsmodus zu treiben. Auf diese Weise kann auch aus einem Signal mit geringer Flankensteilheit ein Ausgangssignal am Knoten 31 erzeugt werden, das eine hohe Flankensteilheit aufweist, so dass die Leistungsverluste am Hauptstufentransistor 19 gering gehalten werden können. Die Flankensteilheit kann, wie bereits erwähnt, durch die weitere Triggerung am Hauptstufentransistor 19 weiter verbessert werden.

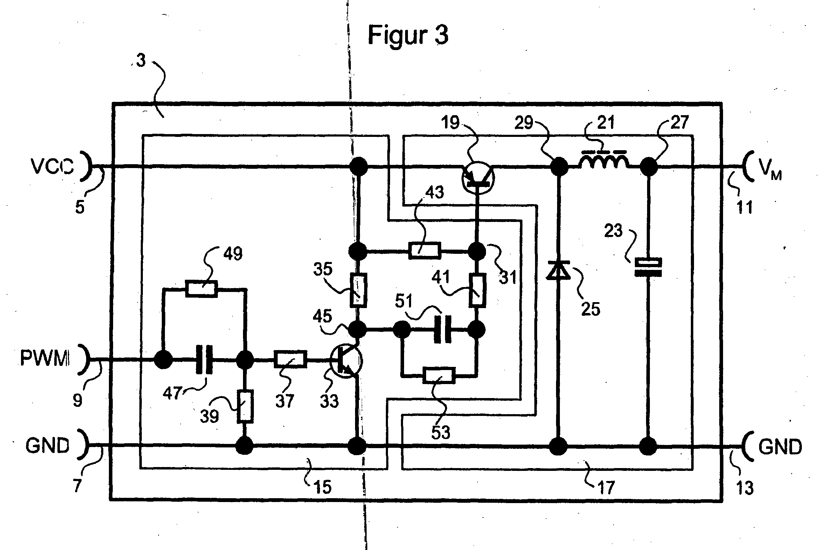

Ein zweites Ausführungsbeispiel für die erfindungsgemäße Steuerschaltung 3 ist in Figur 3 dargestellt. Elemente, die Elementen des ersten Ausführungsbeispiels entsprechen, sind mit denselben Bezugsziffern wie im ersten Ausführungsbeispiel versehen und werden nicht noch einmal beschrieben, um Wiederholungen zu vermeiden.

Die Steuerschaltung des zweiten Ausführungsbeispiels stellt eine Weiterentwicklung des ersten Ausführungsbeispiels da. Sie enthält eine erste Parallelschaltung aus einem Kondensator 47 und einem Widerstand 49, die zwischen den Signaleingang 9 und den Vorstufentransistor 33 geschaltet ist. Sie enthält außerdem eine zweite Parallelschaltung aus einem Kondensator 51 und einem Widerstand 53, die zwischen den Kollektor des Vorstufentransistors 33 und die Basis des Hauptstufentransistors 19 geschaltet ist. Die Kondensatoren 47 und 51 in den beiden Parallelschaltungen sorgen dafür, dass bei einem nicht konstanten Spannungssignal, also während einer an- oder absteigenden Flanke des PWM-Signals, die Spannung dem Strom hinterherhinkt. Dies führt dazu, dass bereits ein Strom an der Basis des Vorstufentransistors 33 bzw. des Hauptstufentransistors 19 fließen kann, der ausreicht, um die Transistoren in den Sättigungsmodus zu treiben, wenn die Spannung den jeweiligen Transistor öffnet. Durch diese Maßnahme kann die Triggerung und somit die Flankensteilheit des Ausgangssignals am Knoten 31 bzw. des Signals am Knoten 29 weiter verbessert werden. Im Übrigen unterscheidet sich die Steuerschaltung 3 des zweiten Ausführungsbeispiels nicht von der Steuerschaltung 3 des ersten Ausführungsbeispiels.

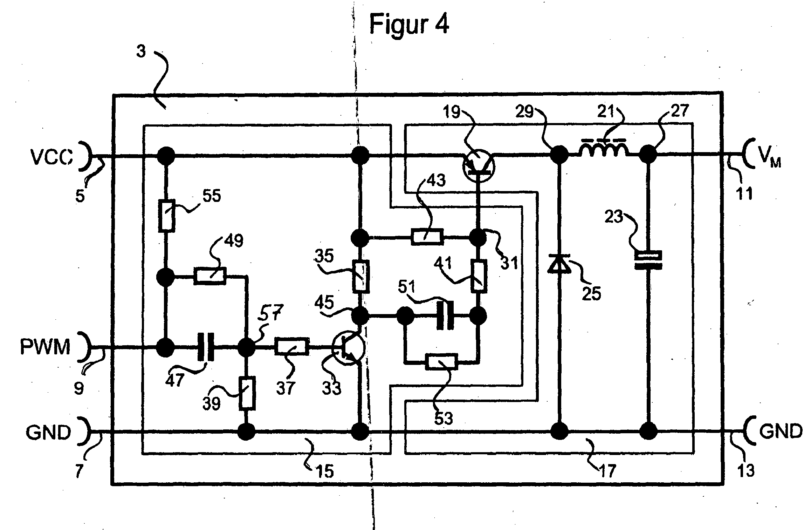

Ein drittes Ausführungsbeispiel für die erfindungsgemäße Steuerschaltung 3 ist in Figur 4 dargestellt. Elemente dieser Steuerschaltung 3, die Elementen der Steuerschaltung 3 des ersten Ausführungsbeispiels oder Elementen der Steuerschaltung 3 des zweiten Ausführungsbeispiels entsprechen, werden mit denselben Bezugsziffern wie im Figur 2 bzw. Figur 3 bezeichnet und nicht noch einmal erläutert, um Wiederholungen zu vermeiden.

Die Steuerschaltung 3 gemäß dem dritten Ausführungsbeispiel unterscheidet sich von der Steuerschaltung 3 gemäß dem zweiten Ausführungsbeispiel lediglich dadurch, dass ein hochohmiger Widerstand 55 zwischen den Versorgungsspannungseingang 5 und den Signaleingang 9 geschaltet ist. Wenn eine Spannung am Signaleingang 9 anliegt, fällt die gesamte Spannungsdifferenz zwischen VCC und der am Signaleingang 9 liegenden Spannung über den hochohmigen Widerstand ab, so dass der Signalpegel des eingehenden PWM-Signals nicht beeinflusst wird. Wenn dagegen der Signaleingang 9 offen ist, fällt die vollständige Versorgungsspannung VCC über die Widerstände 39, 49 und 55 ab. Wenn nun der Widerstand 39 und der Widerstand 37 geeignet gewählt sind, kann am Knoten 57 ein Spannungspegel erreicht werden, der den Vorstufentransistor 33 öffnet. Außerdem lässt sich ein Strom durch die Basis des Vorstufentransistors 33 erreichen, der ausreicht, um den Vorstufentransistor 33 in den Sättigungsmodus zu überführen. Als Folge davon wird auch der Hauptstufentransistor 19 geöffnet und in den Sättigungsmodus überführt. Solange der Signaleingang 9 offen ist, stellt der Motorspannungsausgang 11 daher die maximale Motorspannung V_{M} zur Verfügung, was im Falle des PC-Lüfters aus Figur 1 zu einer maximale Kühlleistung führt. Im Falle eines bspw. aufgrund einer Beschädigung offenen Signaleingangs 9 ist daher auf jeden Fall für eine ausreichende Kühlung gesorgt. Selbstverständlich kann der Widerstand 55 auch in der Schaltungskonfiguration des ersten Ausführungsbeispiels vorhanden sein.

Die beschriebene Erfindung stellt eine Steuerschaltung für einen Gleichstrommotor zur Verfügung, die im Vergleich zu üblichen IC-Lösungen einen sehr einfachen Aufbau besitzt. Mit nur je einem aktiven Bauelement in der Vorstufe und der Hauptstufe ist der Bauelemente- und Produktionsaufwand gegenüber den IC-Lösungen beträchtlich reduziert. Es können daher kostengünstig Steuerschaltungen insbesondere für kleine bis mittlere Ausgangsleistungen realisiert werden. Zudem arbeitet die erfindungsgemäße Steuerschaltung in einem sehr weiten Frequenzbereich. Lediglich die Spule 21 und der Kondensator 23 der Hauptstufe 17 können je nach Anwendung eine Anpassung erfahren. Außerdem ist die eigentliche Pulsweitenregelung weitgehend unabhängig von der Qualität und der Frequenz des Eingangssignals.

Obwohl die Schaltung mit einem npn-Transistor als Vorstufentransistor und einen pnp-Transistor als Hauptstufentransistor realisiert ist, kann sie auch grundsätzlich mit einem pnp-Transistor als Vorstufentransistor und einen npn-Transistor als Hauptstufentransistor realisiert werden, wobei die die Spannungsteilung realisierenden Widerstände entsprechend angepasst werden mussten. Außerdem wäre am Emitter der jeweiligen Transistoren Versorgungsspannungseingang und Masseeingang gegeneinander zu vertauschen. Auch ist es möglich, statt der bipolaren Transistoren Feldeffekttransistoren zu verwenden, wobei wiederum grundsätzlich n-Kanal-Feldeffekttransistoren und p-Kanal-Feldeffekttransistoren zum Einsatz kommen können, wobei für die Beschaltung das hinsichtlich der Bipolartransistoren ausgeführte entsprechend gilt.

## Patentansprüche

1. Steuerschaltung (3) für einen Gleichstrommotor (1) mit einem Versorgungsspannungseingang (5), einer Vorstufe (15) und einer Hauptstufe (17), wobei die Vorstufe (15) als Vorverstärker mit einem Steuersignaleingang (9) und einem Vorstufenausgang (31) zur Ausgabe eines vorverstärkten Steuersignals ausgebildet ist und die Hauptstufe (17) als Tiefsetzstellerschaltung ausgebildet ist, die einen Hauptstufentransistor (19) als Schalter aufweist, dessen Steuereingang mit dem Vorverstärkerausgang (31) verbunden ist, wobei die Vorstufe (15) als einziges aktives Element einen Vorstufentransistor (33) mit einem Steueranschluss, der mit dem Steuersignaleingang (9) verbunden ist, umfasst, **dadurch gekennzeichnet, dass**
der Hauptstrompfad des Vorstufentransistors (33) zwischen den Versorgungsspannungseingang (5) und Masse (7) geschaltet ist und über wenigstens einen Widerstand mit dem Vorverstärkerausgang (31) verbunden ist.

2. Steuerschaltung (3) nach Anspruch 1, in der der Vorstufentransistor (33) ein npn-Transistor bzw. ein n-Kanal-Transistor und der Hauptstufentransistor (19) ein pnp-Transistor bzw. ein p-Kanal-Transistor ist oder umgekehrt.

3. Steuerschaltung (3) nach Anspruch 2,
in der
- der Vorverstärkerausgang (31) über einen Widerstand (43) an den Versorgungsspannungseingang (5) angeschlossen ist und
- der Vorstufentransistor (33) ein npn-Transistor bzw. ein n-Kanal-Transistor ist, dessen Emitter bzw. Source an den Masseeingang (7) angeschlossen ist und dessen Kollektor bzw. Drain über einen Widerstand (35) an den Versorgungsspannungseingang (5) sowie über einen Widerstand (41) an den Vorverstärkerausgang (31) angeschlossen ist,
oder in der
- der Vorverstärkerausgang (31) über einen Widerstand (43) an den Masseeingang (7) angeschlossen ist und
- der Vorstufentransistor (33) ein pnp-Transistor bzw. ein p-Kanal-Transistor ist, dessen Emitter bzw. Source an den Versorgungsspannungseingang (5) angeschlossen ist und dessen Kollektor bzw. Drain über einen Widerstand (35) an den Masseeingang (7) sowie über einen Widerstand (41) an den Vorverstärkerausgang (31) angeschlossen ist.

## Claims

1. A control circuit (3) for a d.c. motor (1) with a supply voltage input (5), a preliminary stage (15) and a main stage (17), wherein the preliminary stage (15) is designed in the form of a pre-amplifier with a control signal input (9) and a preliminary stage output (31) for emitting a pre-amplified control signal and the main stage (17) is designed in the form of a buck converter circuit which has a main stage transistor (19) as a switch, the control input of which is connected to the pre-amplifier output (31), wherein the preliminary stage (15) comprises as the single active element a preliminary stage transistor (33) with a control terminal which is connected to the control signal input (9), **characterized in that** the main current path of the preliminary stage transistor (33) is arranged between the supply voltage input (5) and earth (7) and is connected to the pre-amplifier output (31) by way of at least one resistor.

2. A control circuit (3) according to claim 1, in which the preliminary stage transistor (33) is an npn transistor or an n-channel transistor and the main stage transistor (19) is a pnp transistor or a p-channel transistor, or vice versa.

3. A control circuit (3) according to claim 2, in which
- the pre-amplifier output (31) is connected to the supply voltage input (5) by way of a resistor (43), and
- the preliminary stage transistor (33) is an npn transistor or an n-channel transistor, the emitter or source of which is connected to the earth input (7) and the collector or drain of which is connected to the supply voltage input (5) by way of a resistor (35) and to the pre-amplifier output (31) by way of a resistor (41),
or in which
- the pre-amplifier output (31) is connected to the earth input (7) by way of a resistor (43), and
- the preliminary stage transistor (33) is a pnp transistor or a p-channel transistor, the emitter or source of which is connected to the supply voltage input (5) and the collector or drain of which is connected to the earth input (7) by way of a resistor (35) and to the pre-amplifier output (31) by way of a resistor (41).

## Revendications

1. Circuit de commande (3) pour moteur à courant continu (1), comportant une entrée en tension d'alimentation (5), un étage préliminaire (15) et un étage principal (17), dans lequel l'étage préliminaire (15) est conçu en tant que préamplificateur comportant une entrée de signal de commande (9) et une sortie d'étage préliminaire (31) destinée à émettre un signal de commande préamplifié, et l'étage principal (17) est conçu en tant que circuit de transformateur abaisseur qui présente un transistor d'étage principal (19) en tant que commutateur, dont l'entrée de commande est reliée à la sortie du préamplificateur (31), dans lequel l'étage préliminaire (15) comprend en tant qu'élément actif unique un transistor d'étage préliminaire (33) comportant une borne de commande qui est reliée à l'entrée du signal de commande (9), **caractérisé en ce que** le trajet principal du courant du transistor d'étage préliminaire (33) se fait entre l'entrée en tension d'alimentation (5) et la masse (7) et est relié par au moins une résistance à la sortie du préamplificateur (31).

2. Circuit de commande (3) selon la revendication 1, dans lequel le transistor d'étage préliminaire (33) est un transistor NPN ou un transistor à canal N et le transistor de l'étage principal (19) est un transistor PNP ou un transistor à canal P ou inversement.

3. Circuit de commande (3) selon la revendication 2, dans lequel
- la sortie du préamplificateur (31) est raccordée par une résistance (43) à l'entrée en tension d'alimentation (5) et
- le transistor d'étage préliminaire (33) est un transistor NPN ou un transistor à canal N dont l'émetteur ou source est raccordé(e) à l'entrée de masse (7) et dont le collecteur ou drain est raccordé par une résistance (35) à l'entrée en tension d'alimentation (5) ainsi que par une résistance (41) à la sortie du préamplificateur (31),
ou dans lequel
- la sortie du préamplificateur (31) est raccordée par une résistance (43) à l'entrée de masse (7), et
- le transistor d'étage préliminaire (33) est un transistor PNP ou un transistor à canal P dont l'émetteur ou source est raccordé(e) à l'entrée en tension d'alimentation (5) et dont le collecteur ou drain est raccordé par une résistance (35) à l'entrée de masse (7) ainsi que par une résistance (41) à la sortie du préamplificateur (31).
